**Europäisches Patentamt**

(19) **European Patent Office**

**Office européen des brevets**

(11) Publication number: **0 032 016**
**B1**

(12) **EUROPEAN PATENT SPECIFICATION**

(45) Date of publication of patent specification: **19.03.86**

(21) Application number: **80304532.7**

(22) Date of filing: **16.12.80**

(51) Int. Cl.⁴: **H 01 L 27/02,** H 01 L 21/76,
H 03 K 19/091, H 01 L 21/82

(54) **Method of manufacturing a semiconductor device.**

(30) Priority: **29.12.79 JP 171197/79**

(43) Date of publication of application:
**15.07.81 Bulletin 81/28**

(45) Publication of the grant of the patent:
**19.03.86 Bulletin 86/12**

(84) Designated Contracting States:
**DE FR GB**

(56) References cited:
**US-A-3 904 450**
**US-A-3 982 266**

**IEEE JOURNAL OF SOLID-STATE CIRCUITS,
vol. SC-11, no. 3, June 1976, pages 379-385,
New York, USA C. MULDER et al.: "High speed
integrated injection logic (I2L)"**

(73) Proprietor: **FUJITSU LIMITED**
**1015, Kamikodanaka Nakahara-ku
Kawasaki-shi Kanagawa 211 (JP)**

(72) Inventor: **Funatsu, Tsuneo
430-17-201, Mukaigaoka Takatsu-Ku
Kawasaki-shi Kanagawa 213 (JP)**

(74) Representative: **Sunderland, James Harry et al
HASELTINE LAKE & CO Hazlitt House 28
Southampton Buildings Chancery Lane
London WC2A 1AT (GB)**

# Description

The present invention relates to a method of manufacturing a semiconductor device, more particularly to a device in which lateral transistors and vertical transistors are combined.

A so-called I²L device has a logic element having a composite structure consisting of a so-called reversed structure-type vertical transistor where emitter and collector are inversely provided as compared with an ordinary planar type bipolar transistor and a lateral transistor of complementary type for which the base of the vertical transistor is used as a collector. In such a logic element, the lateral transistor operates as an injector which injects charges into the base of the reversed structure type vertical transistor when a DC power supply voltage is applied to the emitter of the lateral transistor, while the reversed structure type vertical transistor operates as an inverter.

I²L devices have been attracting attention because they allow easy realisation of high integration density simultaneously with low logic voltage swing and high speed operation with less power consumption. I²L elements can exist on the same chip as conventional bipolar type integrated circuit elements.

An I²L device can be obtained by adapting production methods for forming ordinary bipolar ICs, and isolation of I²L elements can be realized using local oxidation technology. It is a characteristic of I²L devices that a collector which corresponds to the emitter of a conventional device is formed in a comparatively wide single base region, and since isolation between collectors is not required, a high integration density can be achieved as mentioned above.

However, considering the functions of I²L devices, semiconductor regions essentially required for I²L device functions are limited to only p-type regions formed face to face in the (pnp type) lateral transistor, and the base region and emitter region immediately below the collector region in the (npn) type vertical transistor, and other base region parts play the role only of conductors and switching characteristics are deteriorated due to junction capacitance and accumulated carrier charges in non-essential regions.

The IEEE Journal of solid state circuits, Vol. SC-11, No. 3, June 1976, pages 379 to 385, discloses a semiconductor device having a lateral bipolar transistor and a vertical bipolar transistor manufactured by a method according to the precharacterising part of claim 1.

According to the present invention there is provided a method of manufacturing a semiconductor device having a lateral bipolar transistor and a vertical bipolar transistor, which method comprises selectively oxidising a semiconductor substrate portion of a first conductivity type to provide first and second mesas of the substrate portion, each mesa surrounded by insulating oxide film, and thereafter forming emitter and collector regions of the lateral transistor in the first mesa and a base contact region of the vertical transistor in the second mesa simultaneously by introduction of impurities of a second conductivity type, into the mesas, and also comprises forming a base region of the vertical transistor by introduction of impurities of the second conductivity type into the second mesa and forming a collector region of the vertical transistor by introduction of impurities of the first conductivity type into the second mesa, and further comprises forming a conductor layer over the insulating film to connect the collector region of the lateral transistor with the base contact region of the vertical transistor; characterised in that the emitter and collector regions of the lateral transistor and the base contact region of the vertical transistor are formed by etching "bird's beak" portions of the insulating film so as to expose underlying parts of the first and second mesas, and by effecting the introduction of impurities to form the emitter and collector regions of the lateral transistor and the base contact regions of the vertical transistor via those exposed parts.

An embodiment of the present invention can provide a semiconductor device of the type mentioned above in which device functions such as switching speed are improved by retaining only essential active areas and by forming an insulating layer in other non-essential areas.

An embodiment of the present invention can provide an I²L device wherein the base region of a vertical transistor is divided as required and bases are mutually connected on a buried insulating film.

An embodiment of the present invention can provide an I²L device in which the emitter region and collector region are each formed in the lateral transistor by introducing impurities into a semiconductor layer exposed by removing a bird's beak portion of the buried insulating film and in which a base contact region is simultaneously formed in the vertical transistor, and a conductive layer is provided to connect the base contact region and collector region.

In an embodiment of the present invention, a plurality of mesa portions are formed on one surface of a semiconductor substrate of one conductivity type. On a first mesa portion the emitter region and collector region of the lateral transistor of an I²L device are formed, while on a second mesa portion the vertical transistor is formed. A buried insulating film which surrounds the mesa portions of the plurality and isolates them is provided on the one surface of the substrate.

It is desirable for the lateral transistor and the vertical transistor to have the minimum dimensions required for transistor action. In order to attain this end, the emitter and collector of the lateral transistor and the base contact region of the vertical transistor are localized adjacent to the buried insulating film.

In an embodiment of the present invention, these regions (the emitter and collector of the lateral transistor and the base contact region of the vertical transistor), are localised by exposing appropriate parts of appropriate mesa portions and by introducing impurities into the exposed parts of the mesa portions. Minimum dimensions are realized by removing birds' beak portions of the buried insulating film (formed by a local oxidation method) by etching, and by introducing impurities into the parts of the mesa portions exposed by removal of the bird's beak portions.

The collector region of the lateral transistor and the base contact region of the vertical transistor are conductively connected by a conductive layer which is deposited on the buried insulating film formed between them.

A plurality of vertical transistor structures on a series of mesa portions and these transistors isolated from one another by the buried insulating film.

In an embodiment of the present invention in which a buried insulating film is employed for vertical transistors of an $I^2L$ device high speed operation of the $I^2L$ device can be realised.

Reference is made, by way of example, to the accompanying drawings, in which:—

Figure 1, (a), (b) are cross-sectional and plan views, respectively, of the basic structure of a conventional $I^2L$ device;

Figure 2, (a), (b), are, respectively, a plan view of major parts of a device made according to an embodiment of the present invention, and a cross-section view of the major parts taken along the line A—A' in (a);

Figures 3 to 8 are respective cross-sectional views of the major parts of a semiconductor device at respective different stages in the course of its production, for assistance in explaining the production of a device made in accordance with an embodiment of the present invention;

Figures 9 to 11 are respective cross-sectional views of a major part of a semiconductor device at respective stages in the production of the device, for assistance in explanation of the etching of an oxide film as employed in a preferred embodiment of the present invention;

Figure 12 (a) is a graph illustrating the relationship between switching time and driving current (power) (on logarithmic scales), of a semiconductor device embodying the present invention;

Figure 12 (b) is a plan view illustrating the dimensions of a conventional $I^2L$ device; and

Figures 13 (a) and 13 (b) are, respectively, a plan view and a cross-sectional view of the vertical transistor of another $I^2L$ device embodying the present invention.

A prior art device of which the present invention provides a development will be explained below.

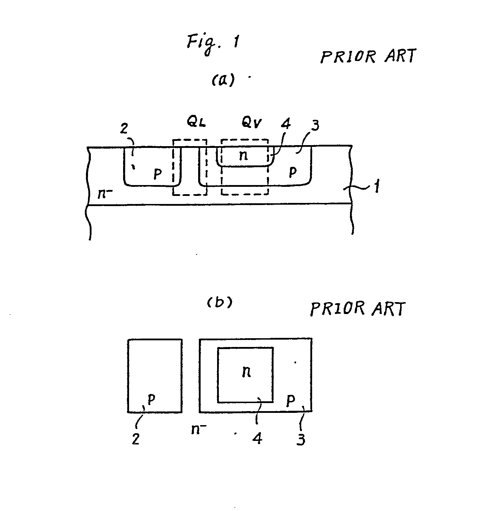

In Figure 1, (a) is a cross-sectional view of principal parts of a conventional $I^2L$ device, while (b) is a plan view of those parts. In Figure 1, p-type regions 2, 3 are formed on an $n^-$-type semiconductor layer 1 formed by epitaxial growth, and an n-type region 4 is formed in the p-type region 3. The parts $Q_L$ indicated by a broken line rectangle form a pnp lateral transistor operating as an injector, while the parts $Q_V$ indicated by a broken line rectangle form an npn vertical transistor operating as an inverter. The junctions included in these active regions $Q_L$, $Q_V$ are required for transistor action but parts forming other junctions play only the role of conductors in operation and moreover result in deterioration of ability of the device to function as a switching element because of capacitance at the junctions and charges accumulated in unwanted parts.

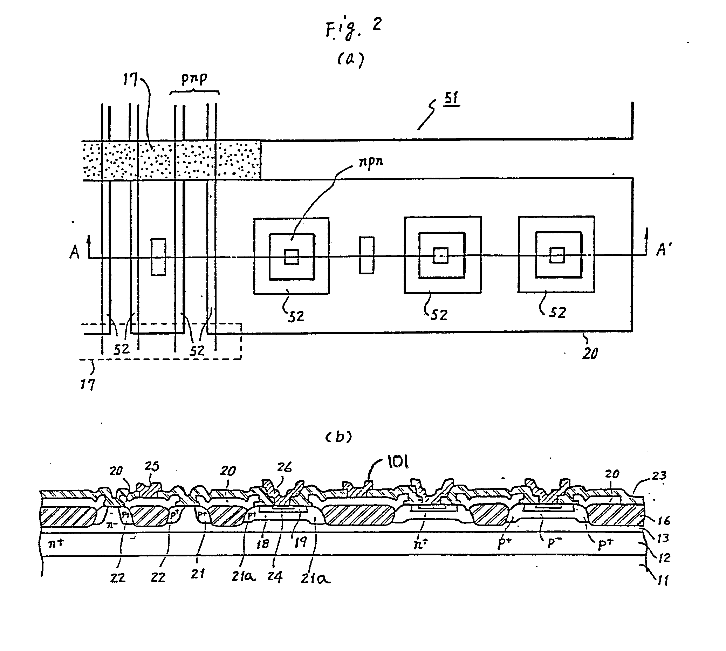

Figure 2 illustrates a device made according to an embodiment of the present invention. In Figure 2, (a) is a plan view of principal parts of the embodiment, while (b) is a cross-sectional view of those parts, viewed in the direction marked by arrows along line A—A' of (a).

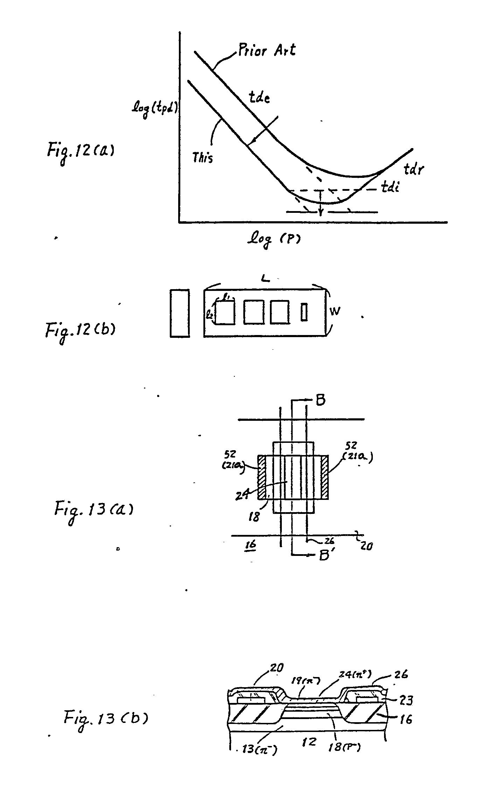

In Figure 2, 11 is a silicon semiconductor substrate; 12 is an $n^+$ buried layer; 13 is an $n^-$ semiconductor layer; 16 is an oxide film; 18 is a $p^-$-type active base region; 19 is an n type region; 20 is a polycrystalline silicon film; 21 and 21a are $p^+$-type regions; 22 is a $p^+$-type region of an injector; 23 is an oxide film; 24 is an $n^+$-type contact region; and 25 and 26 are electrodes. A pnp transistor portion and a npn transistor portion are indicated in Figure 2, (a).

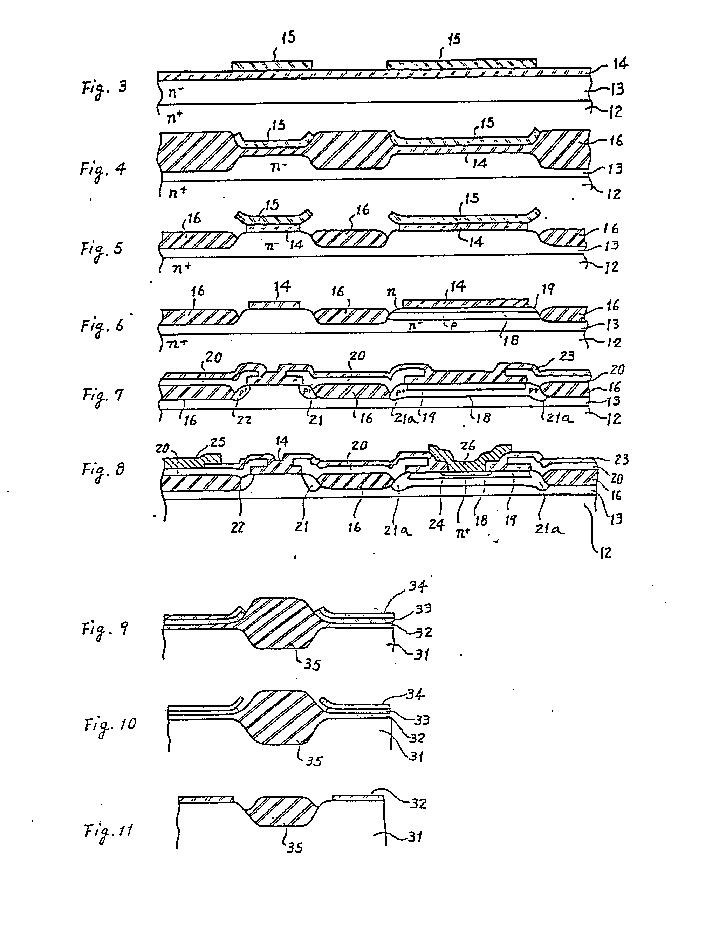

A production process for providing the embodiment shown in Figure 2 will be explained below with reference to Figures 3 to 8 which are respective cross-sectional views of principal parts at different stages in the production process.

With reference to Figure 3:

(1) The $n^+$-type buried layer 12 is formed firstly on a p-type or n-type silicon semiconductor substrate 11 (see Figure 2) and then the $n^-$-type semiconductor layer 13 is formed by an epitaxial growth method to a thickness of about 2 μm or less. For this step, ordinary techniques are used.

(2) An oxide film 14 is formed to a thickness of about 100—130 nm (1000 Å to 1300 Å) by a thermal oxidation process.

(3) A silicon nitride film 15 is formed to a thickness of 250 nm (2500 Å) by a chemical vapour deposition method and portions thereof over what are to be active regions such as a pnp transistor formation region and an npn transistor formation region are retained but other portions of the film 15 are removed by patterning using ordinary photolithographic technology.

With reference to Figure 4:

(4) An oxide film 16 as thick as 1.5 μm or more is formed by a selective thermal oxidation process. This film naturally includes the oxide film 14.

(5) In a next step, etching of the oxide film 16 and 14 is effected for the purpose of exposing parts of the $n^-$-type semiconductor layer 13 in the vicinity of what are to be the active areas and in a succeeding step, $p^+$-type impurity regions are formed in the exposed areas by introducing p-type impurity. Etching of the oxide film 16 and 14 must be done only in a limited area in order to prevent short-circuits between adjacent device elements due to the presence of the $p^+$-type impurity regions. For this reason, a mask 17 consisting of a photoresist film is used in the etching process (see the dotted portion in Figure 2(a), particularly). Namely, etching of oxide film 16 in an area between adjacent device elements (one of which is labelled 51 in Figure 2(a) and the other of which is directly below the element labelled 51 in Figure 2(a)) is blocked and thereby the $n^-$-type semiconductor layer is kept unexposed in this area. In Figure 2(a), 52 indicates an area in which a bird's beak is formed.

With reference to Figure 5:

(6) Etching of oxide film 16 and side etching of the oxide film 14 are carried out. Thereby, the $n^-$-type semiconductor layer 13 is exposed in areas called bird's beak portions. As shown, by this etching of oxide film 16 in bird's beak portions, upper edge parts of the side walls of the mesas are exposed. Adjoining parts of the upper surfaces of the mesas are also exposed. At this time, the thickness of the remaining oxide film 16 was about 700 nm (7000 Å).

With reference to Figure 6:

(7) The silicon nitride film 15 is removed.

(8) A mask of photoresist film (not illustrated) is formed covering the pnp transistor formation region.

(9) Boron ions are injected with an energy of 180 KeV by an ion implantation method and thereby an active base region 18 with a dose of $2 \times 10^{12}$ cm$^{-2}$ is formed:

(10) Then, arsenic ions are injected with an energy of 360 KeV by an ion implantation method and thereby an n-type region (corresponding to a collector) 19 with a dose of $3 \times 10^{13}$ cm$^{-2}$ is formed.

With reference to Figure 7:

(11) Polycrystalline silicon film 20 is formed to a thickness of about 400 nm (4000 Å) by a chemical vapour deposition method.

(12) Patterning is carried out for the polycrystalline silicon film 20 by a photolithography technique.

(13) The polycrystalline silicon film 20 is changed to a conductive film through diffusion of boron. At this time, boron is also diffused into those parts of the $n^-$-type semiconductor layer 13 which are exposed in the bird's beak portions mentioned above, and thereby $p^+$-type regions 21 and 21a and $p^+$-type region 22 of the injector are formed. Here, an oxide film 23 is formed, for example, to a thickness of 300 nm (3000 Å) over the entire surface since a thermal diffusion process is carried out in an oxidising ambient.

With reference to Figure 8:

(14) An impurity diffusion window is opened in the oxide film 23, 14 by a photolithography technique and then n-type impurity is diffused. Thereby, $n^+$-type contact region 24 is formed.

(15) The electrodes 25, 26 are formed by providing electrode contact windows by a photolithography technique.

In the device produced in the process described above, all unwanted areas as explained with reference to Figure 1 are composed of the oxide film 16.

In the views of Figures 5 to 8 (most clearly in Figure 5) oxide film 16 appears to form islands between which mesa portions (formed from semiconductor layer 13) are provided.

In an embodiment of the present invention, it is important to expose parts of the $n^-$-type semiconductor layer (13) by etching the above-mentioned bird's beak portions. Therefore, one preferred method of etching these bird's beak portions is explained with reference to Figures 9 to 11.

With reference to Figure 9:

(1) An oxide film 32 is formed to a thickness of 50—150 nm (500Å to 1500 Å) by thermal oxidation of a silicon semiconductor substrate 31.

(2) A silicon nitride film 33 is formed to a thickness of about 100—400 nm (1000Å to 4000 Å) by a chemical vapour deposition method.

(3) A silicon dioxide film 34 is formed to a thickness of about 100—400 nm (1000 Å to 4000 Å) by a chemical vapour deposition method.

(4) A region in which a thick oxide film should be formed (to provide an island as seen in Figure 5) is exposed by patterning the silicon dioxide film 34 and the silicon nitride film 33 by a photolithography technique.

(5) An oxide film 35 as thick as about 800—1500 nm (8000 Å to 15000 Å) is formed by a selective oxidation process employing a thermal oxidation process.

With reference to Figure 10:

(6) An oxide film of a thickness of 5—20 nm (50 Å to 200 Å) which is produced in exposed areas (end portions) of the silicon nitride film 33 in the thermal oxidation process at (5) above is removed by an etching method.

(7) Side etching is effected for the silicon nitride film 33 using hot phosphoric acid as etchant. The effective amount in the lateral direction is about 500—1000 nm (5000 Å to 10000 Å).

With reference to Figure 11:

(8) A part of the silicon semiconductor substrate 31 is exposed at a bird's beak portion by etching the oxide film 35. At this time, the silicon dioxide film 34 is also removed by etching.

(9) The silicon nitride film 33 is removed together with the silicon dioxide film 34 formed thereon.

According to this technology, the substrate 31 can be exposed in a so-called bird's beak portion while the thick oxide film 35 and thin oxide film 32 are retained in a condition which is sufficient for practical use.

As will be clear from the above explanation, in an embodiment of the present invention, in a semi-conductor device of the I²L type, active regions for obtaining junctions required for transistor action are kept to a minimum area, and portions which previously have functioned only as conductors are completely composed of oxide film and functions of such conductors are transferred to a conductive layer such as a silicon film on the oxide film, and therefore deterioration in switching characteristics resulting from the presence of extra junctions and capacitances can be prevented.

It has already been proposed that the relationship between propagation delay time tpd and drive current or power (P) of an I²L device is generally as indicated in the graph of Figure 12 (a). Namely, when drive current is comparatively low, an extrinsic delay time indicated by tde is formed, and thereafter delay time has a characteristic defined by an intrinsic delay time tdi and a resistive delay time tdr as current increases.

(a) tde depends on junction capacitance and wiring capacitance, and is inversely proportional to current. Namely,

$$P \, tde \simeq 1/4 \cdot (2-\alpha\alpha'/\alpha) \cdot V \, \Delta V \, (C_{EB} + 2C_{CB})$$

Where the symbols used in the equation above have the following significance:—
  P  : power dissipation per gate
  V  : Injector voltage
  V  : Logic voltage swing
  α  : Common base current gain
  α' : Inverse common base current gain
  $C_{EB}$ : Junction capacitance between emitter and base
  $C_{CB}$ : Junction capacitance between base and collector.

In a conventional I²L device, $C_{EB}/2C_{CB} \simeq 1/1$ to 2/1 but in an I²L device embodying the present invention the value of $C_{EB}$ can be reduced to 1/10 or less because the area becomes $6(l_1 + l_2)d/L.W$ where the dimensions of a conventional I²L·device are determined as indicated in Figure 12 (b). Here, d is the width of the p⁺-type region 21.

(b) tdi depends on the effect of rising of the collector current $I_c$ and accumulated charges in the n⁻-type region 13 and is expressed as,

$$tdi\alpha Q_N^-/I_c\alpha 1/N_D \cdot S_E/S_C$$

Where the symbols used in the above equation have the following significance.

  $Q_N^-$ : Accumulated charges in the n⁻-type region
  $N_D$ : Impurity concentration of the n⁻-type region
  $S_E$ : Area of emitter
  $S_C$ : Area of collector

In the structure of the present invention, $S_E/S_C$ can be reduced to a fraction by decrease of $S_E$.

(c) tdr depends on resistance in the base lateral direction and tpd lower than the level at which tdr and tde cross cannot be realised. In the structure of the present invention, a value similar to the sheet resistivity $\rho_s$ of an ordinary base can be realised by doping with boron of high concentration at the time of base deposition.

Various other embodiments of the present invention can be provided; examples of such embodiments will be described below.

A device having a Schottky collector structure is well known as a type of I²L device. Such a device embodying the present invention can be realised by processes after step (15) above without executing the n⁺ diffusion.

In the above described embodiments, wirings are formed by polycrystalline silicon 20, but this polycrystalline silicon can be replaced with a refractory metal (tungsten, molybdenum, platinum or their silicides for example) to which boron is doped. In such a case, after forming the refactory metal to which boron is doped and after patterning of the metal, oxide film 23 is desirably deposited and the p⁺-type regions 21 and 21a and 22 are also formed by a diffusion process.

Processes (11) to (13) can be modified as follows.

(11) Boron is doped into the exposed portions of n⁻-type semiconductor layer 13 by an ion implantation method and thereby p⁺-type regions 21, 21a and 22 are formed.

(12) The metal layer (of Al, Mo, MoSi for example) is coated over the entire surface and then patterning of the metal layer is performed.

(13) An insulating film 23 is formed by an ordinary chemical vapour deposition method.

Thereafter, when a refractory material such as Mo is used, an external base connection using a metal conductor in place of the polycrystalline silicon can be obtained by a process after step (14) above.

On the other hand, when aluminium, which is not a refractory material, is used, an embodiment of the present invention can be provided with a Schottky collector formation without the need for succeeding diffusion processes.

In the manufacture of the embodiment shown in Figure 2, the n⁻-type semiconductor layer 13 is exposed on all four sides of a rectangular nitride film (nitride film 15 in Figures 3 to 5, see particularly Figure 5) in the npn transistor, but the n⁻-type layer may be exposed by etching only on two facing sides or in some cases only on one side, for reduction in size of device. For example, Figure 13 (a) is a plan view of an npn transistor of I²L device in which the semiconductor layer 13 is exposed only on two facing sides. Figure 13 (b) is a cross-sectional view taken along the line B—B' in Figure 13 (a). In relation to Figures 13, in a step corresponding to step (5) connected with Figure 4, the n⁻-type semiconductor layer 13 is exposed only at the areas indicated by 52 in Figure 13 (a) by executing selective etching of the oxide film 16 and 14, and then the p⁺-type regions 21 and 21a are formed therein by executing p⁺ diffusion. In the window opening process of step (14), positioning margin can be obtained by overlapping upper and lower ends of a mask onto the thick oxide film 16.

In an embodiment of the present invention the lateral transistor and the vertical transistor of an I²L device are formed in independent mesa portions on one surface of a semiconductor substrate. A buried insulating film is provided on the semiconductor substrate. The emitter and collector of the lateral transistor are formed locally on opposite sides of a first mesa portion, while the base contact region of the vertical transistor is formed locally on a second mesa portion, adjacent to the buried insulating film. The collector of the lateral transistor and the base contact region of the vertical transistor are connected via a conductive layer provided on the buried insulating film. A plurality of base contact regions of vertical transistors are connected in common respectively by the conductive layer provided on the buried insulating film. High speed operation of an I²L device can thus be realised by forming transistor regions of the minimum dimensions required for transistor action.

In Figure 2, 101 is a vertical transistor base connection at which a conductor is connected to conductive layer 20 through a window in insulator layer 23.

Above, a birds beak portion is a small portion.

In view of Figure 10 a bird's beak or bird's beak portion is a part of oxide film 35 where its thickness tapers down to that of film 32. It will be seen that this part is removed between Figures 10 and 11.

## Claims

1. A method of manufacturing a semiconductor device having a lateral bipolar transistor and a vertical bipolar transistor, which method comprises selectively oxidising a semiconductor substrate portion (13, 31) of a first conductivity type to provide first and second mesas of the substrate portion, each mesa surrounded by insulating oxide film (16; 35), and thereafter forming emitter and collector regions (21, 22) of the lateral transistor in the first mesa and a base contact region (21a) of the vertical transistor in the second mesa simultaneously by introduction of impurities of a second conductivity type, into the mesas, and also comprises forming a base region (18) of the vertical transistor by introduction of impurities of the second conductivity type into the second mesa and forming a collector region (19) of the vertical transistor by introduction of impurities of the first conductivity type into the second mesa, and further comprises forming a conductor layer (20) over the insulating film (16, 35) to connect the collector region (21) of the lateral transistor with the base contact region (21a) of the vertical transistor; characterised in that the emitter and collector regions (21, 22) of the lateral transistor and the base contact region (21a) of the vertical transistor are formed by etching "bird's beak" portions of the insulating film (16; 35) so as to expose underlying parts of the first and second mesas, and by effecting the introduction of impurities to form the emitter and collector regions (21, 22) of the lateral transistor and the base contact regions (21a) of the vertical transistor via those exposed parts.

2. A method as claimed in claim 1, wherein an anti-oxidant mask (15; 33, 34) is selectively formed on an oxide layer (14, 32) provided on the substrate portion (13, 31), so that only parts of the substrate portion over which the anti-oxidation mask is not formed are selectively oxidised to provide the first and second mesas surrounding by the insulating oxide film (16; 35), wherein the anti-oxidation mask (15; 33, 34) provides also an etching mask for the etching to expose the said underlying parts of the first and second mesas, and wherein parts of the oxide film (16; 35) and layer (14; 32) remaining after the etching serve to restrict the introduction of impurities for forming the emitter and collector regions of the lateral transistor and the base contact region of the vertical transistor to take place only via the said exposed parts.

3. A method as claimed in claim 2, wherein the said introduction of impurities for forming the emitter and collector regions of the lateral transistor and the base contact region of the vertical transistor is effected by deposition of polycrystalline silicon film (20) inter alia over the said exposed parts and by diffusion of impurities of the second conductivity type into the polycrystalline silicon film (20) and also into the said exposed parts.

4. A method as claimed in claim 3, wherein the polycrystalline silicon film (20) is patterned to provide the said conductor layer.

5. A method as claimed in claim 2, wherein the said introduction of impurities for forming the emitter and collector regions of the lateral transistor and the base contact region of the vertical transistor is effected by ion implantation of impurities of the second conductivity type.

6. A method as claimed in claim 1, 2 or 5, wherein the said conductor layer comprises a refractory metal.

7. A method as claimed in any preceding claim, wherein the mesas are rectangular.

8. A method as claimed in any preceding claim, further comprising forming a base connection (101) conductivity connected to the base region (18) of the vertical transistor.

9. A method as claimed in any preceding claim, further comprising forming a collector connection (24, 26) for the vertical transistor on the base region (18) of the vertical transistor in the second mesa. ·

10. A semiconductor device made by a method as claimed in any preceding claim.

## Patentansprüche

1. Verfahren zur Herstellung einer Halbleitervorrichtung mit einem lateralen bipolaren Transistor und einem vertikalen bipolaren Transistor, bei welchem selektiv ein Halbleitersubstrat (13, 31) von einem ersten Leitfähigkeitstyp oxidiert wird, um erste und zweite Mesa auf dem Substratabschnitt zu bilden, von denen jedes Mesa durch isolierenden Oxidfilm (16; 35) umgeben ist, und danach Emitter- und Kollektorbereiche (21, 22) des lateralen Transistors in dem ersten Mesa und ein Basiskontaktbereich (21a) des vertikalen Transistors in dem zweiten Mesa gleichzeitig durch Einführung von Verunreinigungen von einem zweiten Leitfähigkeitstyp in die Mesa gebildet werden, und bei welchem ein Basisbereich (18) des vertikalen Transistors durch Einführung von Verunreinigungen des zweiten Leitfähigkeitstyps in das zweite Mesa gebildet wird und ein Kollektorbereich (19) des vertikalen Transistors durch Einführung von Verunreinigungen des ersten Leitfähigkeitstyps in das zweite Mesa gebildet wird, und bei welchem eine Leiterschicht (20) über dem isolierenden Film (16, 35) gebildet wird, um den Kollektorbereich (21) des lateralen Transistors mit dem Basisbereich (21a) des vertikalen Transistors zu verbinden; dadurch gekennzeichnet, daß der Emitter- und der Kollektorbereich (21, 22) des lateralen Transistors und der Basiskontaktbereich (21a) des vertikalen Transistors durch Ätzung von "Vogelschnabel"-Abschnitten des isolierenden Films (16; 35) gebildet werden, um so die darunter liegenden Teile der ersten und zweiten Mesa zu exponieren, und durch Bewirkung der Einführung von Verunreinigungen, um den Emitter- und den Kollektorbereich (21, 22) des lateralen Transistors und den Basiskontaktbereich (21a) des vertikalen Transistors über jene exponierten Teile zu bilden.

2. Verfahren nach Anspruch 1, bei welchem eine Antioxidationsmaske (15; 33, 34) selektiv auf einer Oxidschicht (14, 32) gebildet wird, die auf dem Substrat (13, 31) vorgesehen ist, so daß lediglich Teile des Substratabschnitts, über denen die Antioxidationsmaske nicht gebildet ist, selektiv oxidiert werden, um die ersten und zweiten Mesa vorzusehen, die von dem isolierenden Oxidfilm (16; 35) umgeben sind, bei welchem die Antioxidationsmaske (15; 33, 34) auch eine Ätzmaske für das Ätzen zum Exponieren der genannten darunter liegenden Teile der ersten und zweiten Mesa vorsieht, und bei welchem Teile des Oxidfilms (16; 35) und der Schicht (14; 32), die nach dem Ätzen übrig bleiben, zur Restriktion der Einführung von Verunreinigungen zur Bildung der Emitter- und Kollektorbereiche des lateralen Transistors und des Basiskontaktbereichs des vertikalen Transistors dienen, damit diese lediglich über die genannten exponierten Teile stattfindet.

3. Verfahren nach Anspruch 2, bei welchem die genannte Einführung von Verunreinigungen zur Bildung der Emitter- und Kollektorbereiche des lateralen Transistors und des Basiskontaktbereichs des vertikalen Transistors durch Deposition von polykristallinem Siliziumfilm (20) bewirkt wird, unter anderem über den genannten exponierten Teil, und durch Diffusion von Verunreinigungen des zweiten Leitfähigkeitstyps in den polykristallinen Siliziumfilm (20) und auch in die genannten exponierten Teile.

4. Verfahren nach Anspruch 3, bei welchem der polykristalline Siliziumfilm (20) gemustert ist, um die genannte Leiterschicht zu bilden.

5. Verfahren nach Anspruch 2, bei welchem die genannte Einführung von Verunreinigungen zur Bildung des Emitter- und Kollektorbereichs des lateralen Transistors und des Basiskontaktbereichs des vertikalen Transistors durch Ionenimplantation von Verunreinigungen des zweiten Leitfähigkeitstyps bewirkt wird.

6. Verfahren nach Anspruch 1, 2 oder 5, bei welchem die genannte Leiterschicht ein hitzebeständiges Material umfaßt.

7. Verfahren nach einem der vorhergehenden Ansprüche, bei welchem die Mesa rechtwinklig sind.

8. Verfahren nach einem der vorhergehenden Ansprüche, bei welchem ferner ein Basisanschluß (101) leitend mit dem Basisbereich (18) des vertikalen Transistors gebildet wird.

9. Verfahren nach einem der vorhergehenden Ansprüche, bei welchem ferner ein Kollektoranschluß (24, 26) für den vertikalen Transistor an dem Basisbereich (18) des vertikalen Transistors in dem zweiten Mesa gebildet wird.

10. Halbleitervorrichtung, hergestellt durch ein Verfahren nach einem der vorhergehenden Ansprüche.

**Revendications**

1. Procédé de fabrication d'un dispositif à semiconducteurs comportant un transistor bipolaire latéral et un transistor bipolaire vertical, ce procédé consistant à oxyder sélectivement une partie de substrat semiconducteur (13, 31) d'un premier type de conductivité pour obtenir des première et seconde mesas de la partie de substrat, chaque mesa étant entourée par un film d'oxyde isolant (16;35), et à former ensuite des régions d'émetteur et de collecteur (21, 22) du transistor latéral dans la première mesa et une région de contact de base (21a) du transistor vertical dans la seconde mesa d'une manière simultanée en introduisant des impuretés d'un second type de conductivité, dans les mesas, et consistant également à former une région de base (18) du transistor vertical en introduisant des impuretés du second type de conductivité dans la seconde mesa et à former une région de collecteur (19) du transistor vertical en introduisant des impuretés du premier type de conductivité dans la seconde mesa, et consistant en outre à former une couche conductrice (20) sur le film isolant (16,35) pour connecter la région de collecteur (21) du transistor latéral à la région de contact de base (21a) du transistor vertical; caractérisé en ce que les régions d'émetteur et de collecteur (21, 22) du transistor latéral et la région de contact de base (21a) du transistor vertical sont formées en attaquant des parties en bec d'oiseau du film isolant (16;35) de manière à exposer des portions sous-jacentes des première et seconde mesas, et en effectuant l'introduction d'impuretés pour former les régions d'émetteur et de collecteur (21,22) du transistor latéral et la région de contact de base (21a) du transistor vertical par ces portions exposées.

2. Procédé de fabrication selon la revendication 1, caractérisé en ce qu'un masque d'anti-oxydation (15;33,34) est formé sélectivement sur une couche d'oxyde (14,32) prévue sur la partie de substrat (13,31), de sorte que les portions de la partie de substrat sur lesquelles le masque d'anti-oxydation n'est pas formé sont sélectivement oxydées pour obtenir les première et seconde mesas entourées par le film d'oxyde isolant (16;35), le masque d'anti-oxydation (15;33,34) fournissant également un masque d'attaque pour l'attaque destinée à exposer les portions sous-jacentes des première et seconde mesas, et les portions du film d'oxyde (16;35) et de la couche (14;32) restant après l'attaque servant à limiter l'introduction d'impuretés pour former les régions d'émetteur et de collecteur du transistor latéral et la région de contact de base du transistor vertical pour qu'elle ne se produise que par les portions exposées.

3. Procédé de fabrication selon la revendication 2, caractérisé en ce que ladite introduction d'impuretés pour former les régions d'émetteur et de collecteur du transistor latéral et la région de contact de base du transistor vertical est effectuée en déposant un film de silicium polycristallin (20) inter alia sur les portions exposées et en diffusant des impuretés du second type de conductivité dans le film de silicium polycristallin (20) et également dans les portions exposées.

4. Procédé de fabrication selon la revendication 3, caractérisé en ce que le film de silicium polycristallin (20) a un dessin tracé pour fournir la couche conductrice.

5. Procédé de fabrication selon la revendication 2, caractérisé en ce que l'introduction d'impuretés pour former les régions d'émetteur et de collecteur du transistor latéral et la région de contact de base du transistor vertical est effectuée par une implantation ionique d'impuretés du second type de conductivité.

6. Procédé de fabrication selon l'une quelconque des revendications 1, 2 ou 5, caractérisé en ce que la couche conductrice est constituée d'un métal réfractaire.

7. Procédé de fabrication selon l'une quelconque des revendications 1 à 6, caractérisé en ce que les mesas sont rectangulaires.

8. Procédé de fabrication selon l'une quelconque des revendications 1 à 7, caractérisé en ce qu'il consiste en outre à former une connexion de base (101) connectée d'une manière conductrice à la région de base (18) du transistor vertical.

9. Procédé de fabrication selon l'une quelconque des revendications 1 à 8, caractérisé en ce qu'il consiste en outre à former une connexion de collecteur (24, 26) pour le transistor vertical sur la région de base (18) du transistor vertical dans la seconde mesa.

10. Dispositif à semiconducteurs fabriqué par un procédé tel que revendiqué dans l'une quelconque des revendications 1 à 9.

Fig. 1

PRIOR ART

(a)

(b)          PRIOR ART

Fig. 2

(a)

(b)

Fig. 3

Fig. 4

Fig. 5

Fig. 6

Fig. 7

Fig. 8

Fig. 9

Fig. 10

Fig. 11

Fig.12(a)

Prior Art

tde

log(tpd)

This

tdr

tdi

Log (P)

Fig.12(b)

L

ℓ₁

ℓ₂

W

Fig. 13 (a)

B

52
(21a)

52
(21a)

24

18

16

26

B'

20

Fig. 13 (b)

20

19(π⁻)

24(n⁺)

26

23

16

13(π⁻)

12

18(P)

4